# EUROPÄISCHE PATENTSCHRIFT

(11) **EP 3 714 520 B1**
(45) Veröffentlichungstag und Bekanntmachung des Hinweises auf die Patenterteilung: **21.02.2024**
(21) Anmeldenummer: 18815508.9
(22) Anmeldetag: 14.11.2018
(51) Int. Cl.: H02G 3/22, H02G 15/013, H01R 13/52, H02B 1/30, H02G 3/18

(54) **KABELDURCHFÜHRUNG**
CABLE FEEDTHROUGH
TRAVERSÉE DE CÂBLE

(30) Priorität: 24.11.2017 DE 102017127774; 14.12.2017 DE 102017129923
(43) Veröffentlichungstag der Anmeldung: 30.09.2020
(73) Patentinhaber: HARTING Electric Stiftung & Co. KG, 32339 Espelkamp (DE)
(72) Erfinder: SCHÖNFELD, Alexander, 49086 Osnabrück (DE); KLIEVER, Wilhelm, 32425 Minden (DE); FRIESEN, Heinrich, 32429 Minden (DE); HERMONI, Christof, 32339 Espelkamp (DE)
(86) Internationale Anmeldenummer: PCT/DE2018/100930
(87) Internationale Veröffentlichungsnummer: WO 2019/101268

(56) Entgegenhaltungen:
- EP-A2- 0 901 190
- DE-B3-102010 046 857
- DE-C1- 19 723 032
- DE-U1- 29 911 305
- JP-U- S57 161 282

## Beschreibung

Die Erfindung betrifft eine Kabeldurchführung eines insbesondere vorkonfektionierten elektrischen Kabels. Die Erfindung betrifft dabei außerdem insbesondere eine mit einer Dichtung versehene Kabeldurchführung in ein Gehäuse.

### Stand der Technik

Beispielsweise der DE 10 2006 062 609 A1 ist ein recht umfassender Überblick über Kabeldurchführungen für elektrische Kabel zu entnehmen, wobei ein Kabel vielfach zuerst durch eine in einer Gehäusewand vorgesehene Kabeldurchführung geführt und daraufhin das Kabel bestimmungsgemäß beispielsweise an einem Stecker durch Löten befestigt wird.

Das ist jedoch verhältnismäßig umständlich und erfordert nach dem Durchführen des Kabels noch den zusätzlichen Arbeitsgang der Steckerbefestigung. Weiterhin müssen bei Kabeln mit vorkonfektionierten Steckern die Stecker für die Montage entfernt werden, was aufwendig zu handhaben und dementsprechend kostspielig ist.

Die Kabeldurchführung der DE 10 2006 062 609 A1 ist dabei ein Beispiel der Bauart, bei der zur Abdichtung mittels einem Verschraubungsstutzen ein Druck auf eine Dichtung bereitgestellt wird.

Die DE 299 11 305 U1 zeigt ein Kabel-Stecker-Durchführsystem für/an elektrische und/oder elektronische Bauteile aufnehmende Gehäuse, mit zwei an einer Gehäusewand durch Schrauben im Bereich eines Durchbruches festlegbaren Halbschalen mit in die Halbschalen eingesetzten flexiblen und/oder elastischen Einsätzen mit einem Durchlaßloch mit einem vom Durchlaßloch zum Einsatzrand verlaufenden Einführschlitz für das Kabel mit Stecker, wobei die beiden Halbschalen die Einsätze in den Halbschalen und gegen die Gehäusewand unter Anpreß- und Dichtverbindung halten. Die beiden Halbschalen nehmen die Einsätze in Ausformungen formschlüssig auf, und werden durch einen die Halbschalen übergreifenden Abdeckrahmen mit Schrauben an der Gehäusewand befestigt. Dabei drückt der Abdeckrahmen mit einer konischen Pressfläche gegen einen konischen Schalenrand der Halbschalen, wodurch die Einsätze zusammengepresst werden. Die Einsätze und die Halbschalen weisen dabei eine unterschiedliche Shorehärte auf.

Die DE 197 23 032 C1 zeigt eine abgedichtete Kabeleinführung zur Einführung elektrischer Kabel in Steckverbinder-Gehäuse oder Schaltgeräte mit mindestens zwei übereinander angeordneten geschlitzten Dichtelementen, die übereinander derart in ein Rahmenteil eingelegt sind, daß die vorgestanzten Schlitze jeweils über dem nicht vorgestanzten Bereich des anderen Dichtelementes angeordnet sind. Ein flächiges, anschraubbares Druckteil übt beim Anschrauben einen Anpreßdruck auf die Dichtelemente aus.

Die DE 10 2010 046 857 B3 zeigt eine Kabeldurchführung, insbesondere für einen Verteilerschrank der Telekommunikations- und Datentechnik, umfassend eine Wand- oder Bodenplatte, die mindestens eine Öffnung aufweist, in der ein Kabel mit einem Dichtelement angeordnet ist. Das Dichtelement ist in einer sich verjüngenden Vertiefung der Wand- oder Bodenplatte angeordnet, und ein Druckelement übt eine Kraft auf das Dichtelement aus, wobei das Druckelement das Dichtelement in Richtung der Verjüngung drückt.

Die JP S57 161 282 U zeigt eine Gehäusedurchführung für mehrere Kabel, wobei die Kabel über eine Dichtung mit geschlitzten Kabelöffnungen abgedichtet sind.

Die EP 0 901 190 A2 versucht die genannten Nachteile zu beheben und stellt eine mit einer Dichtung versehene Kabeldurchführung für ein mit einem Stecker vorkonfektioniertes Kabel in ein Gehäuse bereit, bei der an einer Wand des Gehäuses ein Durchbruch zur Durchführung eines Steckers vorgesehen ist. Der Durchbruch wird dabei mit einer zweigeteilten und zusammensetzbaren Haube mit Durchlässen für ein oder mehrere Kabel abgedeckt, in die ein blockförmiger und flexibler und/oder elastischer Einsatz mit einem zu seinem Einsatzrand geschlitzten Kabel-Einlegeloch eingesetzt ist. Der Einsatz geht mit der Haube und der Gehäusewand einen Pressdruck ein, so dass eine Dichtverbindung bereitgestellt ist.

Der Schlitz des blockförmigen Einsatzes gestattet zwar ein Einführen des Kabels in das Kabel-Einlegeloch. Nachdem der Einsatz blockförmig ausgebildet ist und lediglich an seinem Rand unter lediglich zum Einsatzloch axialem Pressdruck von Gehäuse und Wand steht, ist der Schlitz des Einsatzes zur Sicherstellung der Dichtung zick-zack-förmig ausgebildet. Außerdem ist dabei die Dimension des Durchbruchs insbesondere in seiner Breite erheblich eingeschränkt. Auch bei mehreren Einsätzen lediglich am Rand eines Einsatzes ausgebildete keilförmige Ausprägungen, die mit entsprechenden Vorsprüngen der Haube zusammenwirken, bewirken lediglich einen Pressdruck auf den Rand eines benachbarten Einsatzes und haben somit keinen Einfluss auf die Dichtung der Haube, des Schlitzes und des Einlegelochs mit dem Kabel.

Der zick-zack-förmige Schlitz des Einsatzes erfordert außerdem eine sehr umständliche und dementsprechend kostspielige Handhabung beim Einführen des Kabels, nachdem der Einsatz dabei an dem Schlitz sowohl axial nach oben und unten als auch radial geöffnet werden muss, was zeitaufwendig und dementsprechend kostspielig ist. Außerdem ist die Kabeldurchführung der EP 0 901 190 A2 aufgrund der Elastizität der Einsatzelemente lediglich für einen Durchbruch mit beschränkten Abmessungen geeignet.

Auch eine Kombination der Kabeldurchführung nach der EP 0 901 190 A2 und der DE 10 2006 062 609 A1 führt zu keiner die vorstehenden Nachteile behebenden Lösung, insbesondere auch nachdem bei der DE 10 2006 062 609 A1 mittels dem Verschraubungsstutzen Druck auf ein Dichtelement ausgeübt wird. Dabei treten nämlich unerwünschte Scherkräfte auf, die sich insbesondere nachteilhaft auf den mit einem Schlitz versehenen Einsatz nach der EP 0 901 190 A2 und dessen bestimmungsgemäße Funktion auswirken.

### Aufgabenstellung

Aufgabe der Erfindung ist demnach, eine einfache und leicht handhabbare und montierbare und dementsprechend auch kostengünstige Kabeldurchführung für insbesondere vorkonfektionierte elektrische Kabel insbesondere in ein Gehäuse bereitzustellen. Dabei ist weiterhin Aufgabe eine entsprechende mit einer zuverlässigen Dichtung versehene Kabeldurchführung bereitzustellen, die außerdem für eine Vielzahl unterschiedlicher Gehäuse und Kabel geeignet ist.

Die Aufgabe wird durch die kennzeichnenden Merkmale des unabhängigen Anspruchs 1 gelöst.

Vorteilhafte Ausgestaltungen der Erfindung sind in den Unteransprüchen und/oder der nachfolgenden Beschreibung angegeben.

Die vorliegende Erfindung umfasst dabei insbesondere eine Kabeldurchführung für wenigstens ein Kabel in ein Gehäuse mit einer Öffnung, die mit einer wenigstens zwei Gehäuseschalen umfassenden Abdeckung mit wenigstens einer Öffnung versehen ist. Die Trennebene der Gehäuseschalen verläuft dabei mittig durch die Öffnung der Abdeckung, und zur Abdichtung des Gehäuses ist wenigstens ein elastisches und/oder flexibles Dichtelement vorgesehen, das einen Kabeldurchlass mit einem Schlitz zu seinem seitlichen Rand umfasst. Außerdem ist eine wenigstens einen Kabeldurchlass umfassende, die Öffnung des Gehäuses abdeckende Gegendruckplatte vorgesehen, die zur Abdichtung des Gehäuses mit dem Dichtelement und der Abdeckung zusammenwirkt, wobei das Dichtelement mit einem vorbestimmten Übermaß zwischen der Abdeckung und der Gegendruckplatte angeordnet ist und damit unter axialem Pressdruck steht. Das Dichtelement weist einen ersten Zylinder auf, der an der Gegendruckplatte aufliegt und in der Umgebung der Öffnung der Abdeckung abgerundet ausgebildet ist, und die Öffnung der Abdeckung ist ausgehend von einem Rand der Öffnung der Abdeckung innenseitig konusförmig erweitert, wodurch eine Kontur bereitgestellt ist, die mit der Abrundung des Dichtelements derart zusammenwirkt, dass das Dichtelement unter dem Pressdruck und unter einer axialen und radialen Kompression ohne Auftreten einer Scherkraft die Abdichtung insbesondere des Kabels, der Abdeckung und seines Schlitzes bereitstellt.

Die Vorsehung der die Öffnung des Gehäuses abdeckenden Gegendruckplatte ist besonders vorteilhaft, nachdem die Gegendruckplatte dem Pressdruck über die gesamte Öffnung insbesondere auch in ihrem zentralen Bereich entgegenwirkt, so dass mittels dem Dichtelement eine über die ganze Öffnung wirkungsvolle Dichtung bereitgestellt ist. Außerdem ist aufgrund der Vorsehung der Gegendruckplatte die Öffnung des Gehäuses nicht in ihrer Dimensionierung beschränkt, so dass ein Zugang auch für eine Vielzahl von mit Steckern beträchtlicher Abmessungen vorkonfektionierte Kabel in das Innere des Gehäuses sichergestellt ist. Die erfindungsgemäße Kabeldurchführung ist somit für eine Vielzahl unterschiedlicher Gehäuse und Kabel flexibel anpassbar und handhabbar.

Für eine handhabbare Einführung des Kabels nach erfolgter bestimmungsgemäßer Positionierung des Kabels in dem Gehäuse kann der Kabeldurchlass der Gegendruckplatte hierbei geeigneter Weise wenigstens eine durchgehende Öffnung und wenigstens einen seitlichen Kabeleinlass zur seitlichen Einführung des Kabels in die Öffnung umfassen.

Weiterhin kann die Gegendruckplatte geeigneter Weise in der Umgebung der Öffnung des Gehäuses auf einer innenseitig an einer Wand des Gehäuses ausgebildeten Auflage aufliegen, die ein Vorsprung sein kann, der um einen vorbestimmten Betrag in das Innere des Gehäuses ragt, so dass eine stabile Positionierung der Gegendruckplatte auf der Auflage bereitgestellt ist und dabei außerdem der Zugang in das Innere des Gehäuses durch dessen Öffnung nicht beeinträchtigt ist. An Stelle des Vorsprungs kann die Auflage auch als Stufung an einer Wand des Gehäuses ausgebildet sein. Für die stabile Positionierung der Gegendruckplatte in dem Gehäuse und der Abdeckung auf dem Gehäuse ragt ein die Öffnung umgebender Rand des Gehäuses dabei geeigneter Weise über die Gegendruckplatte hinaus.

Dabei kann die Gegendruckplatte insbesondere vorteilhaft einstückig ausgebildet sein, wonach sie besonders einfach zu handhaben ist und außerdem gegenüber einem insbesondere auf ihren zentralen Bereich wirkenden Druck besonders stabil ist.

Nach einer Abwandlung der vorstehenden Ausführung kann die Gegendruckplatte zweistückig ausgebildet sein und sich aus zwei im Wesentlichen identisch ausgebildeten Halbplatten zusammensetzen, deren Trennebene mittig durch ihre Öffnung verläuft. Eine derartige zweistückige Gegendruckplatte ist dabei zur Bereitstellung eines stabilen Gegendrucks insbesondere im Bereich ihrer Trennebene mit einer entsprechenden Mächtigkeit (Dicke) ausgebildet. In dem Bereich der Trennebene können die Halbplatten auch miteinander korrespondierend abgestuft ausgebildet sein, wodurch die Stabilität einer entsprechend zusammengesetzten Gegendruckplatte ebenfalls erhöht ist.

Nach einer weiteren Abwandlung kann die Gegendruckplatte aus einer Vielzahl von individuellen im Wesentlichen identisch ausgebildeten Plattenelementen mit jeweils wenigstens einem Kabeldurchlass zur Aufnahme eines Kabels zusammensetzbar ausgebildet sein. Dabei kann ein jeweils mit einem bestimmungsgemäß benachbarten Plattenelement korrespondierender Rand eines Plattenelements geeigneter Weise eine mit dem Rand des benachbarten Plattenelements korrespondierende Kontur aufweisen, wobei die Konturen beispielsweise schwalbenschwanzartig oder schienenartig korrespondierend ausgebildet sein können, so dass ein wünschenswerter Zusammenhalt der zu der Gegendruckplatte zusammengesetzten Plattenelemente bereitgestellt ist.

Die Öffnung der Abdeckung des Gehäuses ist besonders vorteilhaft ausgehend von ihrem Rand innenseitig konusförmig erweitert, wodurch eine Kontur bereitgestellt ist, die mit dem Dichtelement derart zusammenwirkt, dass das Dichtelement unter dem Pressdruck eine axiale und radiale Kompression erfährt, ohne dass dabei unerwünschte Scherkräfte auftreten. Durch diese Maßnahme wird eine besonders wirkungsvolle und zuverlässige Dichtung zwischen dem Kabel, dem Dichtelement und der Abdeckung erreicht, und außerdem der Schlitz des Dichtelements wünschenswert dicht verschlossen.

Hierbei können geeignete Maßnahmen zur stabilen Fixierung der Abdeckung auf dem Gehäuse wie auch zur stabilen Zusammensetzung der Gehäuseschalen zu der Abdeckung vorgesehen sein. Geeigneter Weise können Gehäuse und Abdeckung und die Gehäuseschalen hierfür miteinander verrastbar ausgebildet sein. Die Abdeckung und das Gehäuse können auch miteinander verschraubt werden, wofür geeignete Bohrungen in dem Gehäuse und der Abdeckung vorgesehen sein können.

In die Öffnung der aus zwei Gehäuseschalen bestehenden Abdeckung kann auch ein bereits bestimmungsgemäß in dem Gehäuse positioniertes Kabel auf einfache Weise zwischen die beiden getrennten Gehäuseschalen eingeführt werden, wonach die beiden Gehäuseschalen zu der Abdeckung mit dem in ihre Öffnung eingeführten Kabel zusammengesetzt werden. Die mit der Trennebene der Gehäuseschalen korrespondierenden Seiten der beiden Gehäuseschalen können dabei geeigneter Weise als jeweils miteinander korrespondierende Konturen ausgebildet sein, die formschlüssig derart ineinandergreifen, dass die Abdeckung auch im Bereich der Trennebene ihrer Gehäuseschalen abgedichtet ist.

Das Dichtelement kann vorteilhaft den ersten Zylinder mit einem ersten Durchmesser und einen zweiten Zylinder mit einem zweiten kleineren Durchmesser umfassen, wobei der Kabeldurchlass axial durch den ersten und zweiten Zylinder ausgebildet ist, und der Schlitz sich vorteilhaft in Längsrichtung durch den ersten und zweiten Zylinder zu dem seitlichen Rand des Dichtelements erstreckt. Auf diese Weise ist das Dichtelement besonders einfach handhabbar, da es geeignet ausgebildet ist, ein bereits in dem Gehäuse positioniertes Kabel durch einfaches seitliches Einführen mittels einfach handhabbarer lediglich radialer Öffnung seines Schlitzes in seinen hierdurch freigelegten Kabeldurchlass einzuführen. Die vorteilhafte Ausbildung des Schlitzes in Längsrichtung ist insbesondere möglich, nachdem wie eingangs gesagt mittels der erfindungsgemäßen Kabeldurchführung eine vorteilhafte Kompression des Dichtelements ohne Auftreten von unerwünschten, die Abdichtung des Schlitzes möglicher Weise beeinträchtigenden Scherkräften, bereitgestellt wird.

Der erste Zylinder des Dichtelements kann geeigneter Weise an der Gegendruckplatte aufliegen und vorteilhaft in der Umgebung der Öffnung der Abdeckung abgerundet ausgebildet sein, wodurch das Dichtelement besonders vorteilhaft mit der vorstehend beschriebenen konusförmig erweiterten Öffnung der Abdeckung zusammenwirkt, so dass das Dichtelement unter dem axialen Pressdruck der Abdeckung eine axiale und radiale Kompression erfährt.

Der zweite Zylinder des Dichtelements kann zur einfachen Handhabung und Montage geeigneter Weise formschlüssig mit der Öffnung der Gegendruckplatte in der Öffnung angeordnet sein, wodurch das Dichtelement außerdem stabil auf der Gegendruckplatte positioniert ist.

Das Gehäuse einer vorstehend beschriebenen Kabeldurchführung kann aus Kunststoff und/oder Metall und die Abdeckung geeigneter Weise aus Kunststoff sein, nachdem die Abdeckung aus zwei formschlüssig korrespondierenden Gehäuseschalen zusammengesetzt ist. Die Gegendruckplatte kann, um einem vorstehend beschriebenen Pressdruck wünschenswert entgegenzuwirken geeigneter Weise aus Metall mit einer vorbestimmten Mächtigkeit (Dicke) ausgebildet sein. Das Dichtelement ist vorteilhaft einstückig aus einem geeigneten flexiblen und/oder elastischen dichtenden Material ausgebildet, wobei das Dichtelement auch als Blindstopfen ohne den Kabeldurchlass und den Schlitz ausgebildet sein kann.

Eine vorstehend beschriebene erfindungsgemäße Kabeldurchführung ist insbesondere geeignet für wenigstens ein vorkonfektioniertes elektrisches Kabel, das mit einem Stecker versehen sein kann, wobei wünschenswert ist, insbesondere den Stecker vor Montage der Kabeldurchführung bestimmungsgemäß in dem Gehäuse zu positionieren.

Eine erfindungsgemäße Kabeldurchführung kann außerdem für eine Vielzahl von Kabeln ausgelegt sein.

Eine erfindungsgemäße Kabeldurchführung ist wie vorstehend beschrieben auf einfache Weise handhabbar und montierbar und dementsprechend auch kostengünstig und gestattet eine zuverlässige Dichtung und flexible Verwendung mit einer Vielzahl von unterschiedlich ausgebildeten Kabeln und Gehäusen.

### Ausführungsbeispiel

Ausführungsbeispiele der Erfindung sind in den Zeichnungen dargestellt und werden im Folgenden näher erläutert. Es zeigen:
- Fig. 1: eine perspektivische Explosionsdarstellung einer Kabeldurchführung einer Ausführung der Erfindung mit einem Gehäuse mit einer Abdeckung, einer Gegendruckplatte und Dichtelementen und mit einem vorkonfektionierten Kabel;
- Fig. 2a: die Abdeckung von Fig. 1;
- Fig. 2b: das Gehäuse von Fig. 1;
- Fig. 2c: das Gehäuse von Fig. 1 von oben;
- Fig. 3a: Ausführungen eines individuellen Dichtelements der Ausführung von Fig. 1;
- Fig. 3b: eine Abwandlung des Dichtelements von Fig. 3a;
- Fig. 3c: die Gegendruckplatte von Fig. 1 von oben;
- Fig. 3d: eine Abwandlung der Gegendruckplatte von Fig. 3c;
- Fig. 3e: eine weitere Abwandlung der Gegendruckplatte von Fig. 3c;
- Fig. 4a bis d: Schritte bei der Montage der Kabeldurchführung von Fig. 1;
- Fig. 5a bis d: weitere Schritte bei der Montage der Kabeldurchführung von Fig. 1;
- Fig. 6a: die vollständig montierte Kabeldurchführung von Fig. 1;
- Fig. 6b: eine vergrößerte Darstellung des Ausschnitts A1 eines Schnitts entlang der Linie SL-SL von Fig. 6a;
- Fig. 6c: eine vergrößerte Darstellung des Ausschnitts A2 von Fig. 6b; und
- Fig. 6d: eine vergrößerte Darstellung des Ausschnitts A3 von Fig. 6b mit einem abgewandelten Gehäuse.

Die Figuren enthalten teilweise vereinfachte, schematische Darstellungen. Zum Teil werden für gleiche, aber gegebenenfalls nicht identische Elemente identische Bezugszeichen verwendet. Verschiedene Ansichten gleicher Elemente könnten unterschiedlich skaliert sein.

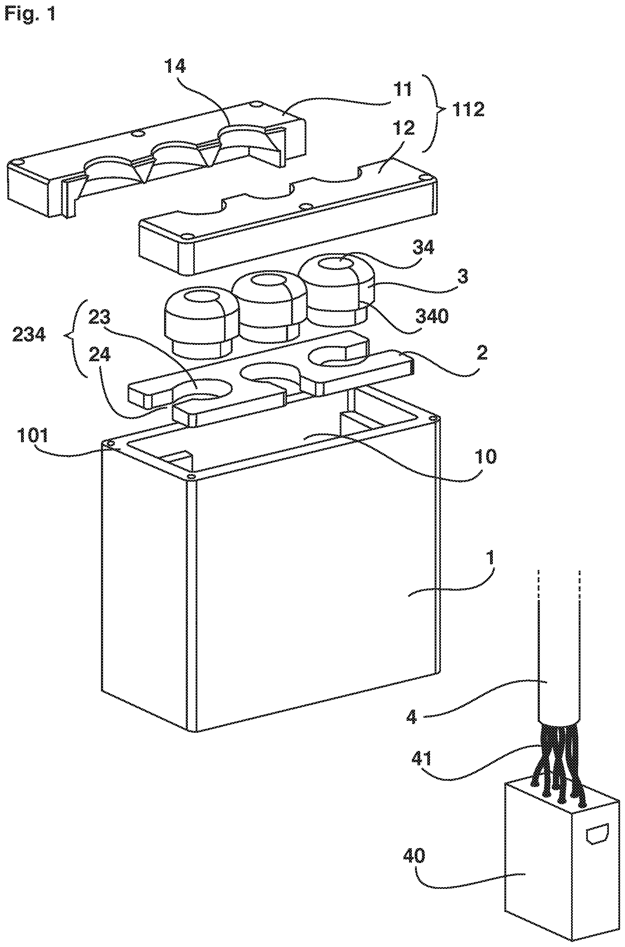

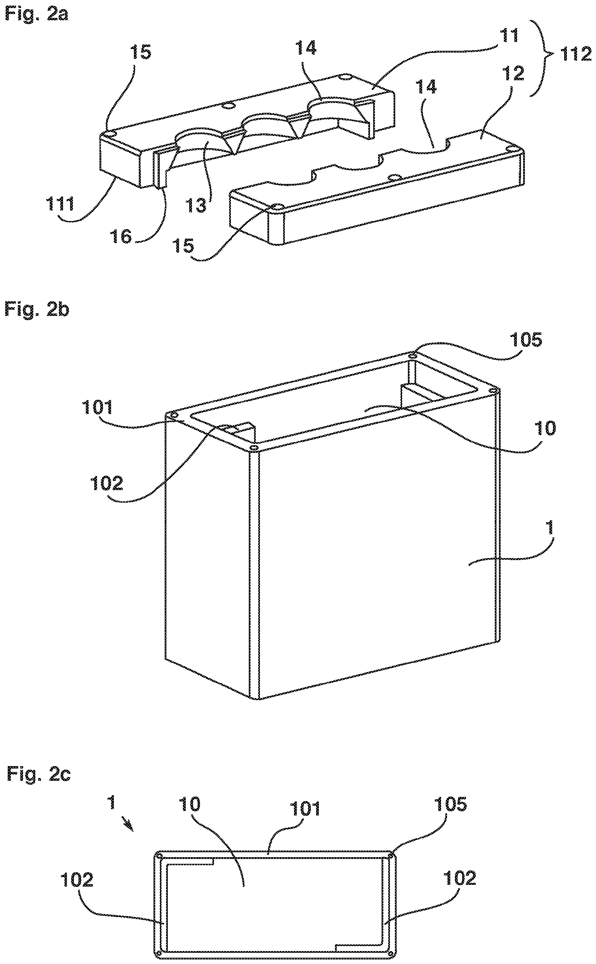

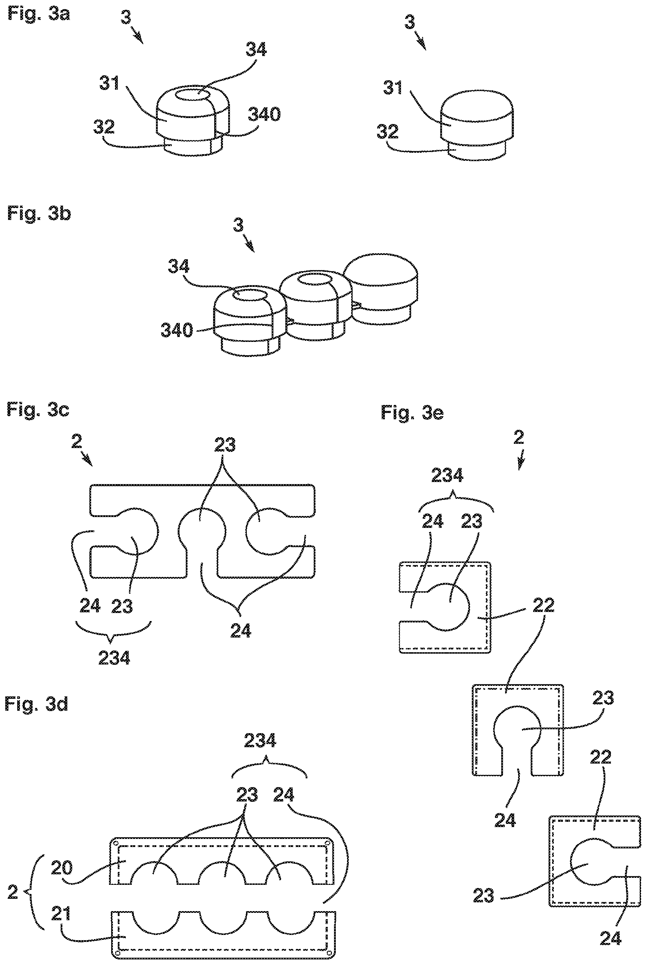

Figur 1 zeigt eine perspektivische Explosionsdarstellung einer Kabeldurchführung nach einer Ausführung der Erfindung mit einem Gehäuse 1 mit einer Abdeckung 112, einer Gegendruckplatte 2 und mehreren Dichtelementen 3 zusammen mit einem geeigneten vorkonfektionierten Kabel 4 der Übersichtlichkeit halber lediglich mit wenigen Bezugszeichen. Eine detailliertere Beschreibung der vorstehenden Elemente mit weiteren Bezugszeichen folgt unter Bezugnahme auf Figur 2a bis c und Figur 3a bis d.

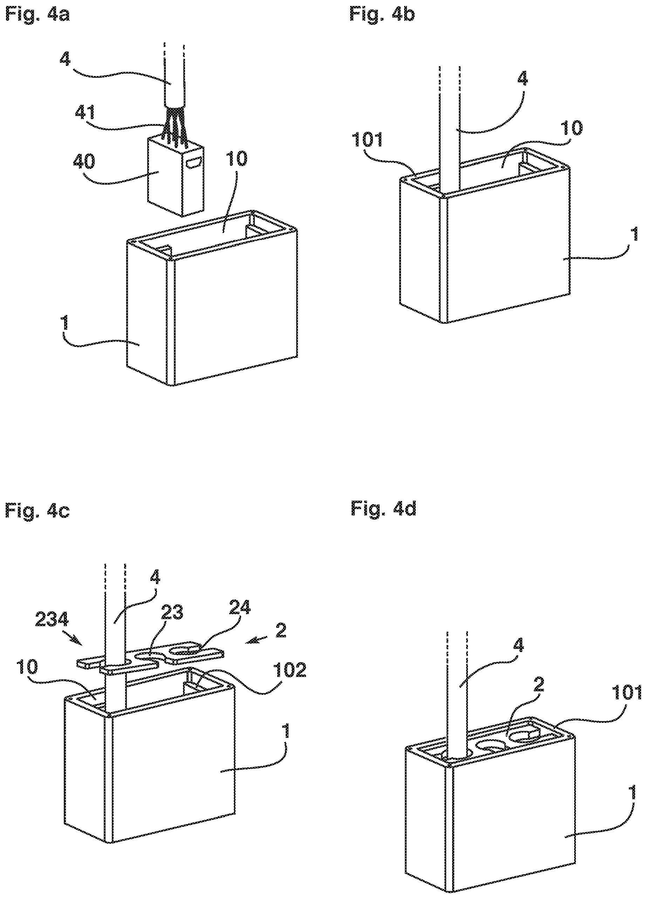

Das vorkonfektionierte Kabel 4 umfasst eine Vielzahl von Litzen 41, die mit einem Stecker 40 verbunden sind, und ist für die Kabeldurchführung von Fig. 1 geeignet. Eine detaillierte Beschreibung der Montage der Kabeldurchführung mit dem Kabel 4 folgt unter Bezugnahme auf Figur 4a bis d und Figur 5a bis d und Figur 6a.

Das Gehäuse 1 umfasst eine obere Öffnung 10, die einen Zugang in das Innere des Gehäuses 1 gestattet und geeignet ist, das vorkonfektionierte Kabel 4 mit seinem Stecker 40 auf einfache Weise bestimmungsgemäß in dem Gehäuse 1 zu positionieren. Das Gehäuse 1 umfasst außerdem eine aus zwei Gehäuseschalen 11, 12 zusammengesetzte Abdeckung 112 mit mehreren Öffnungen 14 zur Aufnahme eines bereits in dem Gehäuse 1 positionierten Kabels 4 und weiterer Kabel 4, wobei eine zusammengesetzte und auf die Öffnung 10 aufgesetzte Abdeckung 112 die Öffnung 10 des Gehäuses 1 verschließt.

Innerhalb des Gehäuses 1 ist in der Nähe der Öffnung 10 eine Auflage 102 für die Gegendruckplatte 2 vorgesehen. Die Gegendruckplatte 2 umfasst einen Kabeldurchlass 234 mit einem Kabeleinlass 24 und einer Öffnung 23, die es gestatten, ein bereits bestimmungsgemäß in dem Gehäuse 1 positioniertes Kabel 4 aufzunehmen.

Ein Dichtelement 3 aus flexiblem und/oder elastischem Material umfasst einen axialen Kabeldurchlass 34 mit einem Schlitz 340, der sich ausgehend von dem Kabeldurchlass 34 zu einem seitlichen Rand des Dichtelements 3 erstreckt. Auf diese Weise ist das Dichtelement 3 geeignet ausgebildet, ein bereits bestimmungsgemäß in dem Gehäuse 1 positioniertes Kabel 4 mittels dessen seitlichen Einführens durch den Schlitz 340 in seinen axialen Kabeldurchlass 34 aufzunehmen. Ein zwischen der Abdeckung 112 und der Gegendruckplatte 2 angeordnetes Dichtelement 3 ist außerdem gegenüber der auf das Gehäuse 1 aufgesetzten Abdeckung 112 und der in das Gehäuse 1 eingesetzten Gegendruckplatte 2 mit einem vorbestimmten Übermaß ausgebildet, wobei es teilweise in die Öffnung 23 der Gegendruckplatte 2 formschlüssig eingreift und außerdem eine vorbestimmte Press- und Dichtverbindung zwischen Kabel 4, Dichtelement 3, Gegendruckplatte 2 und Abdeckung 112 bereitgestellt ist.

Figur 2a zeigt die schalenförmig ausgebildete Abdeckung 112 des Gehäuses 1 mit ihren beiden Gehäuseschalen 11 und 12, deren Trennebene mittig durch die Öffnungen 14 zur Durchführung des Kabels 4 verläuft. Die Öffnungen 14 der Abdeckung 112 sind ausgehend von dem Rand der Öffnungen 14 mit der Kontur 13 innenseitig konusförmig erweitert, um geeignet mit Dichtelementen 3 zusammenzuwirken, die nachfolgend unter Bezugnahme auf Fig. 3a und b beschrieben werden. Zur Befestigung der zusammengesetzten und mit ihrem unteren Rand 111 auf den Rand 101 des Gehäuses 1 aufgesetzten Abdeckung 112 auf dem Gehäuse 1 umfasst die Abdeckung 112 für Schrauben geeignete Bohrungen 15.

Geeigneter Weise sind die mit ihrer Trennebene korrespondierenden Seiten der beiden Gehäuseschalen 11 und 12 jeweils als miteinander korrespondierende Konturen 16 ausgebildet, die formschlüssig derart ineinandergreifen, dass die Abdeckung 112 auch im Bereich der Trennebene abgedichtet ist. Zur Bereitstellung einer besonders zuverlässigen Dichtung der beiden Gehäuseschalen 11 und 12 ist die Abdeckung 112 hierfür aus einem geeigneten Kunststoff ausgebildet. Zusätzlich oder alternativ kann die Abdeckung 112 dabei im Bereich ihrer Trennebene ein weiteres schnurartiges Dichtelement umfassen.

Figur 2b zeigt das Gehäuse 1 von Figur 1 mit der Öffnung 10 und einer Auflage 102 für die Gegendruckplatte 2, und Figur 2c zeigt eine Draufsicht auf das Gehäuse 1 von Figur 2b von oben. Die Öffnung 10 hat den Rand 101 zum Aufsetzen der Abdeckung 112, der mit dem Rand 111 der Abdeckung 112 korrespondiert. In dem Rand 101 des Gehäuses 1 sind Bohrungen 105 zur Fixierung der Abdeckung 112 mittels Schrauben vorgesehen, die mit den Bohrungen 15 der Abdeckung 112 korrespondieren. In dem Gehäuse 1 ist weiterhin in der Nähe der Öffnung 10 eine für die Gegendruckplatte 2 geeignete Auflage 102 vorgesehen. Die Auflage 102 der Ausführung von Figur 1 und 2 ist hierfür beispielhaft als zwei Stufungen ausgebildet, die sich jeweils über zwei gegenüberliegende Wände des Gehäuses 1 erstrecken und die sich teilweise auf diesen Wänden benachbarte, ebenfalls gegenüberliegende Wände fortsetzen.

Die Auflage 102 der Ausführung von Fig. 2b und c kann auch als Vorsprung ausgebildet sein, der sich ausgehend von der Wand des Gehäuses 1 um einen vorbestimmten Betrag in das Innere des Gehäuses 1 erstreckt, so dass eine stabile Positionierung der Gegendruckplatte 2 auf der Auflage 102 bereitgestellt ist, und dabei außerdem der Zugang in das Innere des Gehäuses 1 durch die Öffnung 10 beim Einführen des vorkonfektionierten Kabels 4 nicht beeinträchtigt ist. Die Auflage 102 der Ausführung von Fig. 2b und c ist besonders geeignet für die einstückig ausgebildete Gegendruckplatte 2 der Ausführung von Fig. 1 und 3c.

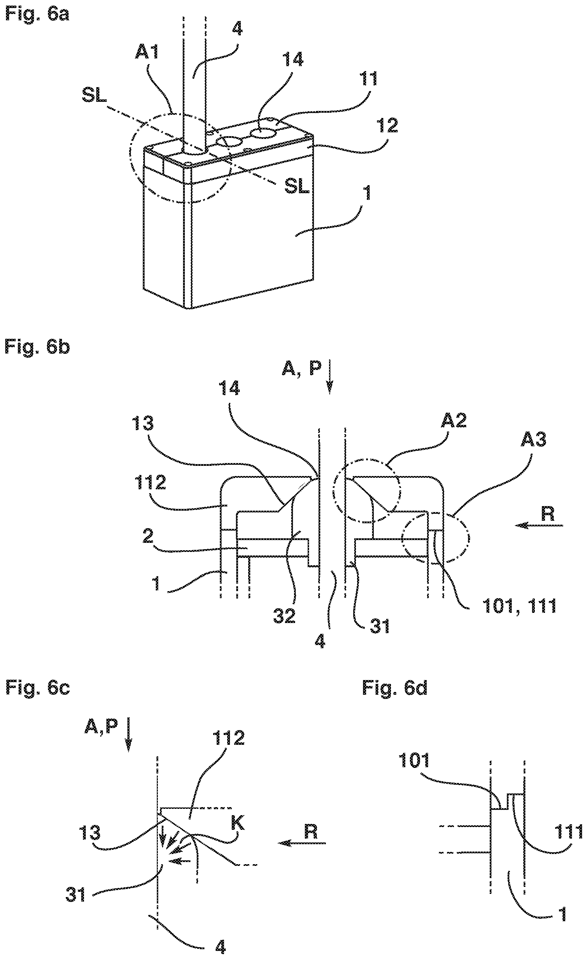

Figur 3a zeigt eine Ausführung eines Dichtelements 3 von Figur 1 zusammen mit einem als Blindstopfen ausgebildeten Dichtelement 3, die im Wesentlichen einen ersten Zylinder 31 mit einem ersten Durchmesser auf einem zweiten Zylinder 32 mit einem zweiten kleineren Durchmesser umfassen. Das Dichtelement 3 umfasst den axialen Kabeldurchlass 34, von dem ausgehend sich der seitliche Schlitz 340 in Längsrichtung durch den ersten 31 und zweiten 32 Zylinder zu dem seitlichen Rand des Dichtelements 3 erstreckt. Das elastische und/oder flexible Dichtelement 3 kann auf einfache Weise über den Schlitz 340 lediglich radial zu seiner Achse geöffnet und dadurch der Kabeldurchlass 34 zur seitlichen Einführung des Kabels 4 freigelegt werden. Der erste Zylinder 31 ist zur geeigneten Zusammenwirkung mit dem Konus 13 der Innenkontur der Abdeckung 112 in der Umgebung ihrer Öffnung 14 oben abgerundet ausgebildet, was auch nachfolgend unter Bezugnahme auf Figur 6b und c beschrieben wird.

Figur 3b zeigt drei Dichtelemente 3, die gemäß der Ausführung von Figur 3a ausgebildet sind und anders als die individuellen Dichtelemente 3 von Figur 3a am unteren Rand des ersten Zylinders 31 über eine flache Verbindung miteinander verbunden sind, wobei beispielhaft ein Dichtelement 3 als Blindstopfen ausgebildet sein kann. Die Verbindung der Dichtelemente 3 lediglich am unteren Rand ihrer ersten Zylinder 31 stellt sicher, dass die Dichtelemente 3 durch die Verbindung in ihrer bestimmungsgemäßen Funktion nicht beeinträchtigt sind.

Figur 3c zeigt die Gegendruckplatte 2 von Figur 1 von oben und Figur 3d eine Abwandlung der Gegendruckplatte 2 von Figur 3c, die im Wesentlichen zweidimensional mit einer vorbestimmten Mächtigkeit ausgebildet sind.

Die Gegendruckplatte 2 von Fig. 3c umfasst die Kabeldurchlässe 234 jeweils mit einem seitlichen Kabeleinlass 24 und einer Öffnung 23, die es gestatten, ein bereits bestimmungsgemäß in dem Gehäuse 1 positioniertes Kabel 4 aufzunehmen. Dabei erstrecken sich die Kabeleinlässe 24 ausgehend von den Öffnungen 23 jeweils zu einem seitlichen Rand der Gegendruckplatte 2, so dass die Öffnungen 23 zum seitlichen Einführen eines Kabels 4 über die Kabeleinlässe 24 zugänglich sind. Die Gegendruckplatte 2 von Figur 3c ist vorteilhaft einstückig ausgebildet und besonders geeignet für die Ausführung des Gehäuses 1 mit der Auflage 102 von Figur 2b und c.

Die Gegendruckplatte 2 von Figur 3d entspricht mit ihren Öffnungen 23 der Ausführung von Figur 3c, und ist anders als die Gegendruckplatte 2 von Figur 3c wie die Abdeckung 112 zweistückig ausgebildet und setzt sich aus zwei im Wesentlichen identisch ausgebildeten Halbplatten 20, 21 zusammen, deren Trennebene mittig durch die Öffnungen 23 verläuft. Dabei hat die Gegendruckplatte 2 einen Kabeldurchlass 234 mit einem für alle Öffnungen 23 gemeinsamen Kabeleinlass 24, der beim Zusammenfügen ihrer beiden Halbplatten 20, 21 geschlossen wird. Die Gegendruckplatte 2 von Figur 3d ist für die Ausführung des Gehäuses 1 mit der Auflage 102 von Figur 2b und c ebenfalls geeignet, wobei für eine besonders stabile und sichere Auflage ein entsprechend abgewandeltes Gehäuse 1 auch eine an seinen inneren Wänden voll umlaufende geschlossene Auflage 102 umfassen kann. Die Gegendruckplatte 2 von Figur 3d ist außerdem besonders geeignet für die Ausführung der Dichtelemente 3 von Fig. 3b.

Die Gegendruckplatte 2 der Ausführung von Figur 3e umfasst drei individuelle jeweils mit einem Kabeldurchlass 234 versehene Plattenelemente 22, die zu der im Wesentlichen der Gegendruckplatte 2 von Figur 3c entsprechenden Gegendruckplatte 2 zusammensetzbar sind. Die drei Plattenelemente 22 sind mit ihrem Kabeleinlass 24 und ihrer Öffnung 23 im Wesentlichen identisch ausgebildet. Die ihren jeweils benachbarten Plattenelementen 22 zugeordneten Ränder können dabei geeigneter Weise miteinander korrespondierende Konturen aufweisen. Diese Möglichkeit ist in Figur 3e jeweils durch gestrichelte Linien veranschaulicht. Dabei können die Ränder der Plattenelemente 22 beispielsweise schwalbenschwanzartig oder schienenartig korrespondierend ausgebildet sein, so dass ein wünschenswerter Zusammenhalt der zu der Gegendruckplatte 2 zusammengesetzten Plattenelemente 22 bereitgestellt ist. Wie die Gegendruckplatte 2 von Figur 3d ist die Gegendruckplatte 2 von Figur 3e für die Ausführung des Gehäuses 1 mit der Auflage 102 von Figur 2b und c ebenfalls geeignet, wobei für eine besonders stabile und sichere Auflage ein entsprechend abgewandeltes Gehäuse 1 auch eine an seinen inneren Wänden voll umlaufende geschlossene Auflage 102 umfassen kann.

Wie vorstehend unter Bezugnahme auf Fig. 1 beschrieben, steht das Dichtelement 3 unter Press- und Dichtverbindung, wobei die Gegendruckplatte 2 hinreichend stabil zur Bereitstellung eines Gegendrucks auf das Dichtelement 3 ausgebildet ist, wonach sich auch das Material und die Mächtigkeit der Gegendruckplatte 2 bestimmt. Um die hierfür erforderliche Mächtigkeit der Gegendruckplatte 2 möglichst gering zu halten ist die Gegendruckplatte 2 geeigneter Weise aus Metall ausgebildet und die Mächtigkeit der Gegendruckplatte 2 der Ausführung von Figur 3d gegenüber der Ausführung von Figur 3c erhöht, um einem Druck insbesondere im Bereich der Trennebene ihrer Halbplatten 20, 21 entgegenzuwirken. Der Bereich der Trennebene der Halbplatten 20, 21 kann dabei auch miteinander korrespondierend abgestuft ausgebildet sein, wodurch die Stabilität einer entsprechend zusammengesetzten Gegendruckplatte 2 im Bereich der zusammengesetzten Abstufungen ebenfalls erhöht ist.

Die Gegendruckplatte 2 von Figur 3d kann auch derart dimensioniert sein, dass sie direkt auf dem Rand 101 der Öffnung 10 des Gehäuses 1 aufliegt, wobei die Gegendruckplatte 2 an ihrem Rand jeweils eine Stufung, eine Kontur oder ein Profil umfassen kann, das formschlüssig mit dem Rand 101 des Gehäuses 1 und/oder dem Rand 111 der Abdeckung 112 korrespondiert. Diese Möglichkeit ist durch die gestrichelte Linie in Figur 3d angedeutet. Natürlich können dabei auch weitere Dichtmaßnahmen zwischen Gehäuse 1, Gegendruckplatte 2 und Abdeckung 112 an deren Rändern getroffen werden. Außerdem kann eine derartige Gegendruckplatte 2 auch geeignete Bohrungen umfassen, die mit den Bohrungen 15 und 105 von Abdeckung 112 und Gehäuse 1 korrespondieren.

Figur 4a bis 4d zeigen Schritte bei der Montage der Kabeldurchführung von Fig. 1 am Beispiel lediglich eines vorkonfektionierten Kabels 4, wobei in Figur 1 das Kabel 4 an dessen Litzen 41 mit einem Stecker 40 bestückt ist und von oben in die Öffnung 10 des Gehäuses 1 eingeführt wird. In Figur 4b sind der Stecker 40 und das Kabel 4 an ihrer vorbestimmten Position in dem Gehäuse 1 positioniert. Hierbei ragt das Kabel 4 aus dem Gehäuse 1 heraus.

Figur 4c zeigt das außerhalb des Gehäuses 1 über einen Kabeleinlass 24 eines Kabeldurchlasses 234 in eine Öffnung 23 der Gegendruckplatte 2 von Figur 1 und 3c eingeführte Kabel 4, und Figur 4d zeigt die in das Gehäuse 1 auf die Auflage 102 bestimmungsgemäß eingesetzte Gegendruckplatte 2. Dabei ist die Gegendruckplatte 2 in der Nähe der Öffnung 10 des Gehäuses 1 angeordnet, und der Rand 101 des Gehäuses 1 ragt geeigneter Weise nach oben über die Gegendruckplatte 2 hinaus. Der überstehende Rand 101 ist für die Positionierung der Gegendruckplatte 2 und für dessen Zusammenwirken insbesondere mit dem Rand 111 der Abdeckung 112 wünschenswert.

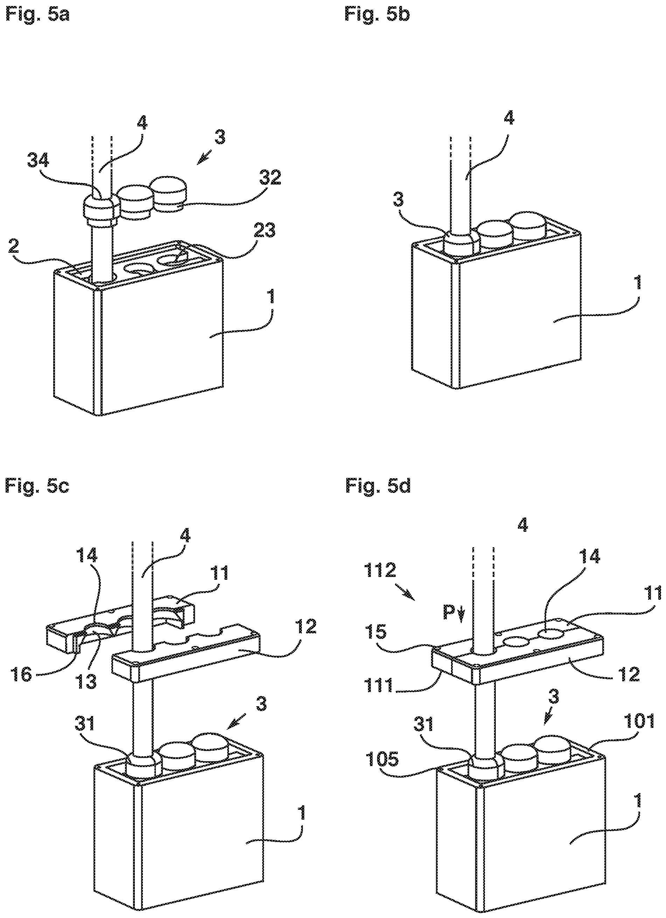

Figur 5a bis 5d zeigen weitere Schritte der Montage der Kabeldurchführung von Figur 1 im Anschluss an die Schritte von Figur 4a bis 4d, wobei in Figur 5a, das Kabel 4 bestimmungsgemäß über den Schlitz 340 eines Dichtelements 3 in dessen axialen Kabeldurchlass 34 eingeführt ist. Nachdem bei dieser Ausführung beispielhaft lediglich ein Kabel 4 in das Gehäuse 1 eingeführt ist, sind zur Bereitstellung einer geeigneten Dichtung die weiteren gleichartigen Dichtelemente 3 als Blindstopfen ohne Kabeldurchlass 34 und Schlitz 340 ausgebildet.

In Figur 5b sind die unteren zweiten Zylinder 32 der Dichtelemente 3 formschlüssig in ihre bestimmungsgemäßen Öffnungen 23 der Gegendruckplatte 2 eingeführt, wonach die Unterseite der oberen ersten Zylinder 31 der Dichtelemente 3 an der Gegendruckplatte 2 aufliegen.

In Figur 5c werden die Gehäuseschalen 11 und 12 auf geeignete Weise relativ zu dem Kabel 4 positioniert, so dass sie zu der Abdeckung 112 von Figur 5d zusammengesetzt werden können, wobei ihre Konturen 16 ineinandergreifen und das Kabel 4 in einer Öffnung 14 mit ihrer innenseitigen konusförmigen Kontur 13 angeordnet ist. Hieran anschließend wird die Abdeckung 112 unter Druck mit ihrem Rand 111 auf den Rand 101 der Öffnung 10 des Gehäuses 1 aufgesetzt, wobei ein Pressdruck P auf die mit vorbestimmtem Übermaß ausgebildeten ersten Zylinder 31 der elastischen und/oder flexiblen Dichtelemente 3 ausgeübt wird und zu deren entsprechender Kompression und Entfaltung ihrer Dichtwirkung führt.

Die Abdeckung 112 wird mittels geeigneter nicht dargestellter Schrauben durch die Bohrungen 15 und 105 von Abdeckung 112 und Gehäuse 1 an dem Gehäuse 1 fixiert, wonach die vollständig montierte Kabeldurchführung von Figur 6a bereitgestellt ist.

Figur 6b zeigt zu der vorstehenden Beschreibung der Montage der Kabeldurchführung unter Bezugnahme auf Figur 5d und 6a eine vergrößerte Darstellung des Ausschnitts A1 eines Längsschnitts durch die Linie SL-SL von Figur 6a mittig entlang der Achse des Kabels 4, und Figur 6c zeigt eine vergrößerte Darstellung des Ausschnitts A2 von Figur 6b.

Bei der Montage der zusammengesetzten Abdeckung 112 auf das Gehäuse 1 wird ein axialer Druck P von oben auf das flexible und/oder elastische Dichtelement 3 ausgeübt, wobei dieser Druck P insbesondere in Zusammenwirken mit dem innenseitigen Konus 13 der Abdeckung 112 und der Abrundung des ersten Zylinders 31 eine vorteilhaft sowohl axiale A als auch radiale R Kompression K des Dichtelements 3 erzeugt, so dass mittels dem Dichtelement 3 eine wünschenswerte Abdichtung der Abdeckung 112, des Kabels 4 in dem Kabeldurchlass 34 und dem Schlitz 340 bereitgestellt ist.

Figur 6d zeigt eine vergrößerte Darstellung des Ausschnitts A3 von Fig. 6b mit einer zur Bereitstellung einer weiteren wünschenswerten Abdichtung des Gehäuses 1 geeigneten abgewandelten Ausbildung des Rands 101 des Gehäuses 1 auf dem der Rand 111 der Abdeckung 112 aufliegt, wobei der Rand 101 und der Rand 111 jeweils korrespondierende formschlüssig ineinandergreifende Konturen aufweisen. Natürlich kann zusätzlich oder alternativ zu der vorstehenden Kontur auch ein geeigneter Dichtring vorgesehen sein.

Das vorstehende Ausführungsbeispiel wurde beispielhaft anhand einer für maximal drei Kabel 4 ausgelegten Kabeldurchführung mit entsprechend drei Dichtelementen 3, etc. beschrieben. Es ist klar, dass weitere Ausführungen auch für mehr oder weniger Kabel 4 ausgelegt sein können.

Auch wenn in den Figuren verschiedene Aspekte oder Merkmale der Erfindung jeweils in Kombination gezeigt sind, ist für den Fachmann - soweit nicht anders angegeben - ersichtlich, dass die dargestellten und diskutierten Kombinationen nicht die einzig möglichen sind. Insbesondere können einander entsprechende Einheiten oder Merkmalskomplexe aus unterschiedlichen Ausführungsbeispielen miteinander ausgetauscht werden.

### Bezugszeichenliste

- 1: Gehäuse
- 10: Öffnung
- 101: Rand
- 102: Auflage (Vorsprung, Stufung)

- 11, 12: Gehäuseschale
- 112: Abdeckung
- 111: Rand
- 13: Kontur, Konus
- 14: Öffnung
- 15: Bohrung
- 16: Kontur (Trennebene)

- 2: Gegendruckplatte
- 20, 21: Halbplatte
- 22: Plattenelement
- 23: Öffnung
- 24: Kabeleinlass
- 234: Kabeldurchlass

- 3: Dichtelement
- 31: erster Zylinder
- 32: zweiter Zylinder
- 34: Kabeldurchlass
- 340: Schlitz
- 4: Kabel
- 40: Stecker
- 41: Litze

- A1, A2, A3: Ausschnitt
- A: Axial
- R: Radial
- P: Druck
- K: Kompression
- SL: Schnittlinie

## Patentansprüche

1. Kabeldurchführung für wenigstens ein Kabel (4) in ein Gehäuse (1) mit einer Öffnung (10), die mit einer wenigstens zwei Gehäuseschalen (11, 12) umfassenden Abdeckung (112) mit wenigstens einer Öffnung (14) versehen ist, wobei
eine Trennebene der Gehäuseschalen (11, 12) mittig durch die Öffnung (14) verläuft; und wobei
zur Abdichtung des Gehäuses (1) wenigstens ein elastisches und/oder flexibles Dichtelement (3) vorgesehen ist, das einen Kabeldurchlass (34) mit einem Schlitz (340) zu seinem seitlichen Rand umfasst
wobei eine wenigstens einen Kabeldurchlass (234) umfassende, die Öffnung (10) abdeckende Gegendruckplatte (2) vorgesehen ist, die zur Abdichtung des Gehäuses (1) mit dem Dichtelement (3) und der Abdeckung (112) zusammenwirkt, wobei das Dichtelement (3) mit einem vorbestimmten Übermaß zwischen der Abdeckung (112) und der Gegendruckplatte (2) angeordnet ist und unter axialem Pressdruck (P) steht, wobei das Dichtelement (3) einen ersten Zylinder (31) aufweist, der an der Gegendruckplatte (2) auffliegt und in der Umgebung der Öffnung (14) der Abdeckung (112) abgerundet ist, und wobei die Öffnung (14) der Abdeckung (112) ausgehend von einem Rand der Öffnung (14) innenseitig konusförmig erweitert ist, wodurch eine Kontur (13) bereitgestellt ist, die mit der Abrundung des Dichtelements (3) derart zusammenwirkt, dass das Dichtelement (3) unter dem Pressdruck (P) eine axiale (A) und radiale (R) Kompression (K) ohne Auftreten einer Scherkraft erfährt.

2. Kabeldurchführung nach Anspruch 1
**dadurch gekennzeichnet, dass**
der Kabeldurchlass (234) der Gegendruckplatte (2) wenigstens eine durchgehende Öffnung (23) und wenigstens einen seitlichen Kabeleinlass (24) zur seitlichen Einführung des Kabels (4) in die Öffnung (23) umfasst.

3. Kabeldurchführung nach Anspruch 1 oder 2
**dadurch gekennzeichnet, dass**
in der Umgebung der Öffnung (10) innenseitig an einer Wand des Gehäuses (1) eine Auflage (102) ausgebildet ist, an der die Gegendruckplatte (2) aufliegt.

4. Kabeldurchführung einem der vorstehenden Ansprüche 1 bis 3 **dadurch gekennzeichnet, dass**
die Gegendruckplatte (2) einstückig ausgebildet ist.

5. Kabeldurchführung nach einem der Ansprüche 1 bis 3
**dadurch gekennzeichnet, dass**
die Gegendruckplatte (2) zweistückig ausgebildet ist und sich aus zwei im Wesentlichen identisch ausgebildeten Halbplatten (20, 21) zusammensetzt, deren Trennebene mittig durch die Öffnung (23) der Gegendruckplatte (2) verläuft.

6. Kabeldurchführung nach einem der Ansprüche 1 bis 3
**dadurch gekennzeichnet, dass**
die Gegendruckplatte (2) aus einer Vielzahl von individuellen Plattenelementen (22) mit jeweils wenigstens einem Kabeldurchlass (234) zusammengesetzt ist.

7. Kabeldurchführung nach einem der vorstehenden Ansprüche 1 bis 6
**dadurch gekennzeichnet, dass**
die mit der Trennebene der Gehäuseschalen (11, 12) korrespondierenden Seiten der beiden Gehäuseschalen (11, 12) jeweils als miteinander korrespondierende Konturen (16) ausgebildet sind, die formschlüssig derart ineinandergreifen, dass die Abdeckung (112) auch im Bereich der Trennebene abgedichtet ist.

8. Kabeldurchführung nach einem der vorstehenden Ansprüche 1 bis 7
**dadurch gekennzeichnet, dass**
das Dichtelement (3) den ersten Zylinder (31) mit einem ersten Durchmesser und einen zweiten Zylinder (32) mit einem zweiten kleineren Durchmesser umfasst, wobei der Kabeldurchlass (34) axial durch den ersten (31) und zweiten (32) Zylinder ausgebildet ist, und der Schlitz (340) sich in Längsrichtung durch den ersten (31) und zweiten (32) Zylinder zu einem seitlichen Rand des Dichtelements (3) erstreckt.

9. Kabeldurchführung nach Anspruch 8
**dadurch gekennzeichnet, dass**
der zweite Zylinder (32) formschlüssig mit der Öffnung (23) der Gegendruckplatte (2) in der Öffnung (23) angeordnet ist.

10. Kabeldurchführung nach einem der vorstehenden Ansprüche 1 bis 9
**dadurch gekennzeichnet, dass**
das Kabel (4) ein vorkonfektioniertes elektrisches Kabel (4) ist, das mit einem Stecker (40) versehen sein kann.

11. Kabeldurchführung nach einem der vorstehenden Ansprüche 1 bis 10
**dadurch gekennzeichnet, dass**
das Gehäuse (1) aus Kunststoff und/oder Metall und die Abdeckung (112) aus Kunststoff ausgebildet ist, und die Gegendruckplatte (2) aus Kunststoff und vorzugsweise aus Metall mit einer vorbestimmten Mächtigkeit (Dicke) ausgebildet ist, und
das Dichtelement (3) einstückig aus einem geeigneten flexiblen und/oder elastischen dichtenden Material ausgebildet ist.

12. Kabeldurchführung nach einem der vorstehenden Ansprüche 1 bis 11 wobei das Dichtelement (3) als Blindstopfen ohne den Kabeldurchlass (34) und den Schlitz (340) ausgebildet ist.

## Claims

1. Cable leadthrough for at least one cable (4) into a housing (1) with an opening (10), which cable leadthrough is provided with a cover (112) comprising at least two housing shells (11, 12) and with at least one opening (14), wherein
a separating plane of the housing shells (11, 12) extends centrally through the opening (14); and wherein,
for sealing off the housing (1), provision is made of at least one elastic and/or flexible sealing element (3) which comprises a cable passage (34) with a slot (340) to its lateral edge, wherein provision is made of a counterpressure plate (2) which comprises at least one cable passage (234) and which covers the opening (10) and which, for sealing off the housing (1), interacts with the sealing element (3) and the cover (112), wherein
the sealing element (3) is arranged with a predetermined oversize between the cover (112) and the counterpressure plate (2) and is subjected to axial pressing pressure (P), wherein the sealing element (3) has a first cylinder (31) which bears on the counterpressure plate (2) and which is rounded in vicinity of the opening (14) of the cover (112), and wherein
the opening (14) of the cover (112), proceeding from an edge of the opening (14), is conically widened at the inner side, whereby provision is made of a contour (13) which interacts with the rounding of the sealing element (3) in such a way that, under the pressing force (P), the sealing element (3) undergoes an axial (A) and radial (R) compression (K) without the occurrence of shear force.

2. Cable leadthrough according to Claim 1,
**characterized in that**
the cable passage (234) of the counterpressure plate (2) comprises at least one continuous opening (23) and at least one lateral cable inlet (24) for lateral insertion of the cable (4) into the opening (23) .

3. Cable leadthrough according to Claim 1 or 2,
**characterized in that**
a support (102) is formed in the vicinity of the opening (10) at the inner side of a wall of the housing (1), on which support the counterpressure plate (2) bears.

4. Cable leadthrough according to one of the preceding Claims 1 to 3,
**characterized in that**
the counterpressure plate (2) is formed in one piece.

5. Cable leadthrough according to one of Claims 1 to 3,
**characterized in that**
the counterpressure plate (2) is formed in two pieces and is made up of two half-plates (20, 21) which are of substantially identical form and whose separating plane extends centrally through the opening (23) of the counterpressure plate (2).

6. Cable leadthrough according to one of the preceding Claims 1 to 3,
**characterized in that**
the counterpressure plate (2) is made up of a plurality of individual plate elements (22) with in each case at least one cable passage (234).

7. Cable leadthrough according to one of the preceding Claims 1 to 6,
**characterized in that**
those sides of the two housing shells (11, 12) which correspond to the separating plane of the housing shells (11, 12) are each formed as mutually corresponding contours (16) which interengage with a form fit in such a way that the cover (112) is sealed off in the region of the separating plane too.

8. Cable leadthrough according to one of the preceding Claims 1 to 7,
**characterized in that**
the sealing element (3) comprises the first cylinder (31), with a first diameter, and a second cylinder (32), with a second, smaller diameter, wherein the cable passage (34) is formed axially through the first cylinder (31) and second cylinder (32), and the slot (340) extends to a lateral edge of the sealing element (3) in a longitudinal direction through the first cylinder (31) and second cylinder (32) .

9. Cable leadthrough according to Claim 8,
**characterized in that**
the second cylinder (32) is arranged in the opening (23) of the counterpressure plate (2) so as to have a form fit with the opening (23).

10. Cable leadthrough according to one of the preceding Claims 1 to 9,
**characterized in that**
the cable (4) is a prefabricated electrical cable (4) which may be provided with a plug (40).

11. Cable leadthrough according to one of the preceding Claims 1 to 10,
**characterized in that**
the housing (1) is formed from plastic and/or metal, and the cover (112) is formed from plastic, and the counterpressure plate (2) is formed from plastic and preferably from metal with a predetermined size (thickness), and
the sealing element (3) is formed in one piece from a suitable flexible and/or elastic sealing material.

12. Cable leadthrough according to one of the preceding Claims 1 to 11, wherein the sealing element (3) is designed as a blind plug without the cable passage (34) and the slot (340).

## Revendications

1. Traversée de câble pour au moins un câble (4) dans un boîtier (1) doté d'une ouverture (10), qui est pourvue d'un couvercle (112) comprenant au moins deux coques de boîtier (11, 12) et doté d'au moins une ouverture (14), un plan de séparation des coques de boîtier (11, 12) s'étendant centralement à travers l'ouverture (14) ; et au moins un élément d'étanchéité (3) élastique et/ou souple étant prévu pour réaliser l'étanchéité du boîtier (1), lequel élément d'étanchéité comprend un passage de câble (34) doté d'une fente (340) vers son bord latéral, une plaque de contre-pression (2) comprenant au moins un passage de câble (234) et recouvrant l'ouverture (10) étant prévue, laquelle coopère avec l'élément d'étanchéité (3) et le couvercle (112) pour réaliser l'étanchéité du boîtier (1), l'élément d'étanchéité (3) étant disposé avec une surdimension prédéfinie entre le couvercle (112) et la plaque de contre-pression (2) et étant soumis à une pression axiale (P), l'élément d'étanchéité (3) présentant un premier cylindre (31) qui repose sur la plaque de contre-pression (2) et est arrondi dans l'environnement de l'ouverture (14) du couvercle (112), et l'ouverture (14) du couvercle (112) s'élargissant en forme de cône du côté intérieur à partir d'un bord de l'ouverture (14), de sorte qu'un contour (13) soit produit, lequel coopère avec l'arrondi de l'élément d'étanchéité (3) de telle sorte que l'élément d'étanchéité (3) soumis à la pression (P) subit une compression (K) axiale (A) et radiale (R) sans qu'aucune force de cisaillement ne survienne.

2. Traversée de câble selon la revendication 1,
**caractérisée en ce que**
le passage de câble (234) de la plaque de contre-pression (2) comprend au moins une ouverture traversante (23) et au moins une entrée de câble (24) latérale pour l'insertion latérale du câble (4) dans l'ouverture (23).

3. Traversée de câble selon la revendication 1 ou 2,
**caractérisée en ce**
**qu'**un support (102) sur lequel la plaque de contre-pression (2) repose est formé dans l'environnement de l'ouverture (10) du côté intérieur sur une paroi du boîtier (1).

4. Traversée de câble selon l'une des revendications précédentes 1 à 3,
**caractérisée en ce que**
la plaque de contre-pression (2) est formée d'une seule pièce.

5. Traversée de câble selon l'une des revendications précédentes 1 à 3,
**caractérisée en ce que**
la plaque de contre-pression (2) est formée en deux pièces et se compose de deux demi-plaques (20, 21) formées de manière sensiblement identique, plaques dont le plan de séparation s'étend centralement à travers l'ouverture (23) de la plaque de contre-pression (2).

6. Traversée de câble selon l'une des revendications précédentes 1 à 3,
**caractérisée en ce que**
la plaque de contre-pression (2) se compose d'une pluralité d'éléments de plaques (22) individuels dotés respectivement d'au moins un passage de câble (234).

7. Traversée de câble selon l'une des revendications précédentes 1 à 6,
**caractérisée en ce que**
les côtés des deux coques de boîtier (11, 12) correspondant au plan de séparation des coques de boîtier (11, 12) sont formés respectivement en tant que contours (16) correspondant les uns aux autres, lesquels viennent en prise avec complémentarité de formes les uns dans les autres de telle sorte que le couvercle (112) est rendu étanche également dans la région du plan de séparation.

8. Traversée de câble selon l'une des revendications précédentes 1 à 7,
**caractérisée en ce que**
l'élément d'étanchéité (3) comprend le premier cylindre (31) doté d'un premier diamètre et un deuxième cylindre (32) doté d'un deuxième diamètre plus petit, le passage de câble (34) étant formé axialement à travers le premier (31) et le deuxième (32) cylindre, et la fente (340) s'étendant dans la direction longitudinale à travers le premier (31) et le deuxième (32) cylindre jusqu'à un bord latéral de l'élément d'étanchéité (3).

9. Traversée de câble selon la revendication 8,
**caractérisée en ce que**
le deuxième cylindre (32) est disposé dans l'ouverture (23) avec complémentarité de formes avec l'ouverture (23) de la plaque de contre-pression (2).

10. Traversée de câble selon l'une des revendications précédentes 1 à 9,
**caractérisée en ce que**
le câble (4) est un câble électrique (4) préfabriqué qui peut être pourvu d'un connecteur (40).

11. Traversée de câble selon l'une des revendications précédentes 1 à 10,
**caractérisée en ce que**
le boîtier (1) est formé à partir de matière synthétique et/ou de métal et le couvercle (112) est formé à partir de matière synthétique, et la plaque de contre-pression (2) est formée à partir de matière synthétique et de préférence à partir de métal présentant une épaisseur (épaisseur) prédéfinie, et
l'élément d'étanchéité (3) est formé d'une seule pièce à partir d'une matière d'étanchéité souple et/ou élastique appropriée.

12. Traversée de câble selon l'une des revendications précédentes 1 à 11, l'élément d'étanchéité (3) étant formé en tant que plot de remplissage sans le passage de câble (34) et la fente (340).
